Europäisches Patentamt

European Patent Office

Office européen des brevets

(11) Veröffentlichungsnummer: **0 666 644 A1**

## (12) EUROPÄISCHE PATENTANMELDUNG

(21) Anmeldenummer: 94101733.7

(51) Int. Cl.⁶: **H03F 3/19**

(22) Anmeldetag: 04.02.94

(43) Veröffentlichungstag der Anmeldung:
09.08.95 Patentblatt 95/32

(84) Benannte Vertragsstaaten:
CH DE DK FR GB IT LI NL SE

(71) Anmelder: **SIEMENS AKTIENGESELLSCHAFT**
**Wittelsbacherplatz 2**
**D-80333 München (DE)**

(72) Erfinder: **Zimmermann, Walter**
**Eichenweg 9**
**D-84405 Dorfen (DE)**

(54) **Monolithisch integrierter Mikrowellen-Breitbandverstärker.**

(57) Ein monolithisch integrierter Mikrowellen-Breitbandverstärker mit zwei in Reihe geschalteten GaAs-Feldeffekttransistoren soll bei hoher Verstärkung und geringem Rauschen mit einer niedrigen Stromaufnahme und niedrigen Betriebsspannungen in einem relativ großen Bereich auskommen. Zwischen Drain (D1) des ersten Transistors (Q1) und Source (S2) des zweiten Transistors (Q2) liegt ein erster Widerstand (R1). Drain (D1) des ersten Transistors (Q1) ist mit Gate (G2) des zweiten Transistors (Q2) hochfrequenzmäßig verbunden. Gate (G1) oder Source (S1) des ersten Transistors (Q1) dienen als HF-Signal-Eingang, wobei die jeweils zweite Elektrode (S1 bzw. G1) hochfrequenzmäßig mit Masse verbunden ist. Source (S2) des zweiten Transistors (Q2) bildet den HF-Signal-Ausgang des Verstärkers.

FIG 1

Die Erfindung betrifft einen monolithisch integrierten Mikrowellen-Breitbandverstärker mit Zwei in Reihe geschalteten GaAs-Feldeffekttransistoren.

Zu den rauscharmen Verstärkern im Mikrowellenbereich gehören bekanntlich auch Feldeffekttransistor-Verstärker. Derartige Verstärker können beispielsweise aus GaAs-Feldeffekttransistoren aufgebaut sein, die als Halbleiterbaustein in Form einer monolithisch integrierten Mikrowellenschaltung MMIC (Microwave Monolithic Integrated Circuit) vorliegen.

Um Breitbandverstärker im Mikrowellenbereich zu realisieren, mußte man allerdings relativ hohe Betriebsströme in Kauf nehmen oder Anpaßnetzwerke verwenden, die die Breitbandigkeit einschränken.

Der Erfindung liegt die Aufgabe Zugrunde, einen Mikrowellen-Breitbandverstärker der eingangs genannten Art zu schaffen, der sich bei hoher Verstärkung und geringem Rauschen durch eine niedrige Stromaufnahme und niedrige Betriebsspannungen in einem relativ großen Spannungsbereich auszeichnet und der als Funktionszelle für eine Vielfalt von HF-Anwendungen geeignet ist.

Diese Aufgabe wird erfindungsgemäß durch einen monolithisch integrierten Mikrowellen-Breitbandverstärker mit den Merkmalen des Anspruchs 1 gelöst.

Vorteilhafte Ausgestaltungen bzw. Weiterbildungen der Erfindung sind Gegenstand zusätzlicher Ansprüche und sind in der Beschreibung anhand der Figuren dargelegt.

Der als Funktionszelle in GaAs-MMIC-Technik entwickelte erfindungsgemäße Breitbandverstärker weist insbesondere folgende Vorteile auf:
- Integrationsfreundlichkeit,
- keine DC-Drossel im Betriebsspannungs-Versorgungspfad erforderlich, damit uneingeschränkte Nutzung der vollen Frequenzbandbreite möglich,
- geringer Strombedarf (z.B. 2mA bis 10mA),
- sehr großer Betriebsspannungsbereich (z.B. 2,5V bis 15V),
- hohe Verstärkung (typisch 8dB bis 16dB, je nach Ausführung),
- großer Funktionsbereich von etwa kleiner 10MHz bis größer 3GHz,
- niedriges Rauschen (typisch 1dB bis 3,5dB je nach Ausführung),
- hohe Rückwärtsisolation (|S12| > 25dB),
- hohe Stabilität (geringe Schwingneigung),
- Signaleinspeisung im Gate (common source) oder Source (common gate) möglich,
- problemlose bedarfsoptimierte Eingangsanpassung unterschiedlicher Ausführung integriert oder extern möglich,
- niederohmige Ausgangsimpedanz (typisch 30 Ohm bis 100 Ohm, je nach Ausführung),
- hohe (optimierte) Ausgangsleistung bezogen auf die DC-Leistungsaufnahme,
- mit verschiedenen Betriebsstromeinstellungen ausführbar,
- problemlos kaskadierbar (gain block),
- als Vor- und Treiberverstärker mit anderen Verstärkern problemlos kombinierbar und
- mit anderen Funktionseinheiten problemlos kombinierbar.

Anhand von in den Figuren der Zeichnung dargestellten Ausführungsbeispielen wird die Erfindung im folgenden näher erläutert. Da es eine Vielzahl von Schaltungsvarianten gibt, sind Funktionszelle, Anpassung und DC-Versorgung anhand von Einzelbeispielen beschrieben, an die sich Bei

spiele für komplette Verstärker-MMICs anschließen. Es zeigen

FIG 1 und 2 Prinzipschaltungen der Funktionszelle,

FIG 3 und 4 Prinzipschaltungen zur Anpassung,

FIG 5 bis 8 Prinzipschaltungen zur DC-Einstellung und

FIG 9 bis 12 Schaltungsanordnungsvarianten kompletter Verstärkerzellen.

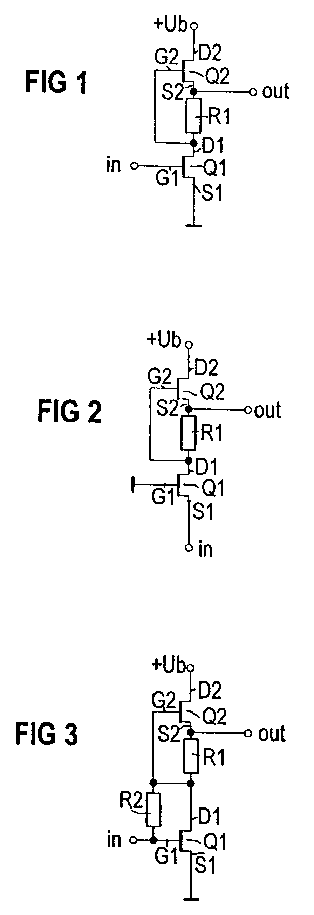

In den FIG 1 und 2 sind Prinzipschaltungen der Funktionszelle des MMIC-Breitbandverstärkers mit dem Signaleinspeisepunkt ins Gate G1 (FIG 1) bzw. in Source S1 (FIG 2) des Feldeffekttransistors Q1 dargestellt. Die beiden GaAs-Feldeffekttransistoren Q1 und Q2 sind in Reihe geschaltet. Zwischen Drain D1 des ersten Transistors Q1 und Source S2 des zweiten Transistors Q2 liegt ein erster Widerstand R1. Drain D1 des ersten Transistors Q1 ist mit Gate G2 des zweiten Transistors Q2 hochfrequenzmäßig verbunden. Gate G1 (FIG 1) oder Source S1 (FIG 2) des ersten Transistors Q1 dienen als HF-Eingang, wobei die jeweils zweite Elektrode, d.h. S1 (FIG 1) bzw. G1 (FIG 2) hochfrequenzmäßig mit Masse verbunden ist. Source S2 des zweiten Transistors Q2 bildet den HF-Signal-Ausgang des Verstärkers.

Beiden Grundausführungen liegt das Funktionsprinzip zugrunde, daß das in den Transistor Q1 eingespeiste Signal dort verstärkt (Spannungsverstärkung) und vom Drain von Q1 dem Gate von Q2 zugeführt wird. Der zweite Feldeffekttransistor Q2 vereint dabei drei wesentliche Funktionen:

a) er stellt dem ersten Feldeffekttransistor Q1 die Betriebsspannung zur Verfügung,

b) die Verbundschaltung Q2 mit R1 bildet am Drain D1 von Q1 eine hochohmige Last, womit der Signalstrom aus Drain D1 in eine hohe Signalspannung umgesetzt wird, und

c) diese Signalspannung wird über die Strecke G2 - Source S2 stromverstärkt (impedanzgewandelt) und an der Source-Elektrode S2 niederohmig herausgeführt.

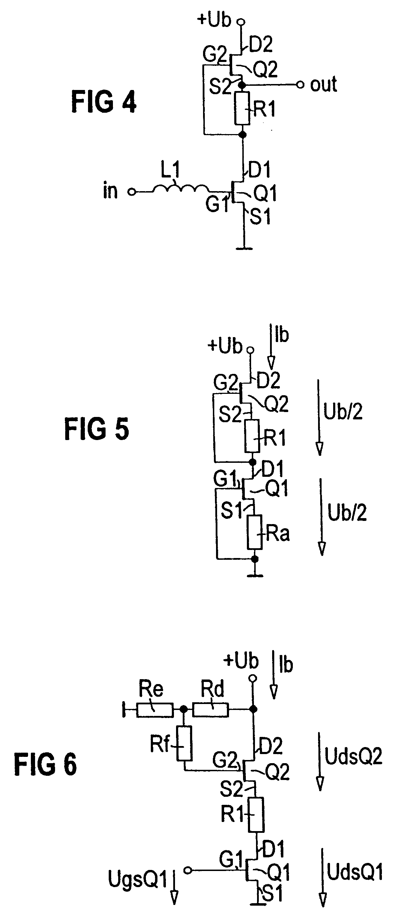

Die sehr geringe Rückwirkung der beschriebenen Funktionszelle erleichtert jede Anpaßmaßnahme erheblich. Die Eingangsimpedanz der Funktionszelle bei Signaleinspeisung ins Gate G1 vom Transistor Q1 ist hochohmig und muß in der Regel an eine niederohmige Quellenimpedanz, vorzugsweise an 50 Ohm, angepaßt werden. Hierfür sind zwei grundsätzliche Möglichkeiten sowie Kombinationen aus beiden gegeben: Anpassung mittels einer resistiven Rückkopplung gemäß FIG 3. Anpassung mittels transformierender Elemente wie Übertrager oder Suszeptanzen gemäß FIG 4.

In FIG 3 ist eine Prinzipschaltung der Funktionszelle mit resistiver Rückkopplung zur Eingangsanpassung dargestellt. Die DC-Erfordernisse sind dabei nicht berücksichtigt. Zwischen der Drain-Elektrode D1 und der Gate-Elektrode G1 des ersten Feldeffekttransistors Q1 ist ein Rückkoppelnetzwerk vorgesehen, das in diesem Beispiel aus dem Rückkoppelwiderstand R2 gebildet ist. Es kann aber auch zweckmäßig sein, als Rückkoppelnetzwerk eine Serienschaltung eines ohmschen Widerstandes mit einem Kondensator zu verwenden. Für die Rückkopplung von D1 auf G1 sorgt in diesem Beispiel der Rückkoppelwiderstand R2. Der Vorteil gegenüber der Strecke S2 auf G1 ist eine geringe Rückwirkung der Gesamtanordnung, ein hochohmiger Widerstand R2 bei gleicher Anpaßwirkung und damit größere Verstärkung sowie geringeres Rauschen. Die resistive Rückkopplung eignet sich für breitbandige Anpassungen mit den Eigenschaften: hohe Bandbreite, z.B. 10MHz bis 3GHz, verbesserte Intermodulationsfestigkeit, Verstärkung um ca. 8dB bis 13dB, Rauschmaß um etwa 3dB bis 4dB und geringe Rückwirkung |S12| > 25dB.

In FIG 4 ist eine Prinzipschaltung der Funktionszelle mit transformativer Anpassung am Eingang ohne Berücksichtigung der DC-Erfordernisse dargestellt. Zwischen HF-Signal-Eingang und Elektrode G1 des ersten Feldeffekttransistors Q1 ist ein Anpaßnetzwerk vorgesehen, das in diesem Ausführungsbeispiel aus einer Serieninduktivität L besteht. Die transformative Anpassung kann aus einem Übertrager oder einer üblichen Kombination von Reaktanzen bestehen. Im Frequenzbereich von 1GHz bis 3GHz genügt vorteilhaft eine hier verwendete einfache Serieninduktivität zwischen HF-Eingang und Gate G1 vom ersten Feldeffekttransistor Q1. Die Anpaßanordnung kann monolithisch integriert und/oder extern vorgenommen werden. Die transformatorische Anpassung eignet sich für hohe Verstärkungen und niedriges Rauschen bei etwas limitierter Bandbreite. Die Eigenschaften sind: hohe Verstärkung um etwa 12dB bis 18dB, niedriges Rauschmaß um etwa 1dB bis 2dB und geringe Rückwirkung |S12| > 25dB.

Bei Signaleinspeisung in Source S1 von Q1 ist eine niederohmige Eingangsimpedanz gegeben, die meist den Erfordernissen genügt oder durch entsprechende Wahl der Eigenschaften von Q1 und dessen Betriebsbedingungen (primär Strom) angepaßt werden kann.

Die Ausgangsimpedanz am Source S2 ist funktionsbedingt niederohmig (typisch 30 Ohm bis 100 Ohm). Sie wird primär durch die Parameter von Q2 und die Größe von R1 festgelegt. Die Parameter von Q2 sind über die Transistoreigenschaften (Transistortechnologie, Transistorgeometrie) und die gewählten Betriebsbedingungen (primär den Betriebsstrom) beeinflußbar. In vielen Fällen genügt die Ausgangsimpedanz den Systemerfordernissen. Erforderlichenfalls kann die Ausgangsimpedanz über ein resistives oder ein transformatives Netzwerk oder ein Splitting von Q2 weiter angepaßt werden. Bei einer unter dem Zielwert liegenden Ausgangsimpedanz kann der Transistor Q2 und der Widerstand R1 in zwei Teilzweige aufgespalten werden, wobei nur ein Teilzweig mit dem Ausgang verbunden ist.

Es gibt mehrere unterschiedliche Möglichkeiten der Einstellung der DC-Betriebsbedingung für die Funktionszelle. Vorteilhafte Prinzipien sind in den Fig. 5 bis 8 gezeigt. Zur besseren Übersicht sind nur die für die DC-Einstellung relevanten Elemente dargestellt. Für die jeweilige Verstärkerzelle bzw. Applikation sind dann die für die HF-DC-Trennung relevanten Bauteile wie Trenn- und Blockkondensatoren einzufügen.

Bei der in der FIG 5 dargestellten Prinzipdarstellung einer DC-Beschaltung der Funktionszelle ist der Betriebsstrom Ib durch die Feldeffekttransistoren und Widerstände vorgegeben. Die einfachste DC-Beschaltung erfolgt mit zwei elektrisch wertegleichen Zellen Q1, Ra und Q2, R1. Am Drain D1 vom ersten Feldeffekttransistor Q1 stellt sich ein Potential Ub/2 ein. Vorraussetzung hierfür ist die elektrische Wertegleichheit von dem Transistor Q1 und dem Einstellwiderstand Ra mit dem Transistor Q2 und dem Widerstand R1. Vorteil dieser Anordnung sind die Einfachheit und der geringe Flächenbedarf. Allerdings ist der Betriebsstrom Ib nicht regelbar und die relative Schwankungsbreite von Ib ist etwa proportional der Idss-Streuung der FETs.

Bei der in der FIG 6 dargestellten Prinzipschaltung einer DC-Beschaltung der Funktionszelle ist der Betriebsstrom Ib einstellbar, und zwar über UgsQ1. Die Betriebsspannungen für die beiden Feldeffekttransistoren Q1 und Q2 werden vom Teilerverhältnis Rd/Re der Spannungsteilerwiderstände vorgegeben. In der Regel werden gleiche Widerstände Rd und Re gewählt. Der Vorteil dieser Schaltung besteht in einer gewissen Freiheit in der Wahl von Id und in der Wahl von Q1, Q2 und R1. FETs vom normally-on-type und vom normally-off-type sind verwendbar. Allerdings ist eine externe Einstellung von Id mit UgsQ1 erforderlich.

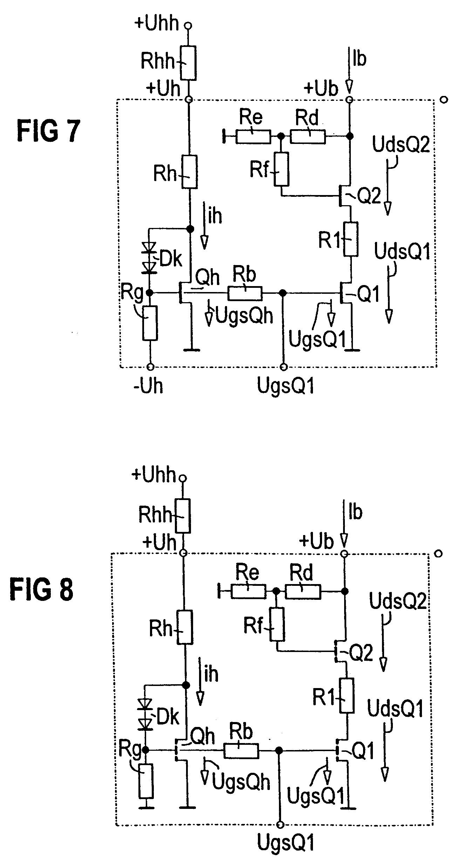

Bei der in FIG 7 dargestellten DC-Beschaltung ist der Betriebsstrom Ib mit externer UgsQ1 einstellbar oder Ib ist mit einer Hilfsspannung Uh oder mit einer externen Hilfsspannung Uhh und externen Hilfswiderstand Rhh geregelt einstellbar. Bei dieser Schaltung wird über eine positive Hilfsspannung Uh und einen Hilfswiderstand Rh für einen Hilfs-Feldeffekttransistor Qh ein Hilfsstrom Ih vorgegeben, der über die Regelschleife Drain von Qh und Diodenkette Dk am Gate von Qh eine Spannung UgsQh einregelt, welche im Transistor Qh einen Drainstrom entsprechend Ih bewirkt. Bei FETs vom normally-on-type wird in der Regel eine negative Gatespannung erforderlich. Diese kann über den Regelkreis nur dann erreicht werden, wenn die Verbindungsstelle Gate von Qh und der Diodenkette Dk mit einem negativen Strom gespeist wird. Im einfachsten Fall wird dies mit einer zusätzlichen negativen Hilfsspannung -Uh und einem Widerstand Rg erreicht. Die positive Hilfsspannung Uh oder Uhh kann identisch sein mit der Betriebsspannung Ub. Bei einer fest vorgegebenen Hilfsspannung Uhh kann der Hilfsstrom Ih durch die Wahl eines externen Widerstandes Rhh eingestellt werden. Da die beiden Feldeffekttransistoren Qh und Q1 am gleichen Gatepotential UgsQh = UgsQ1 liegen, wird am Transistor Q1 ein Betriebsstrom Ib = Ih • (wgQ1/wgQh) eingestellt. Dabei ist wgQ1/wgQh das Gateweitenverhältnis der entsprechenden FETs mit gleicher Gatelänge. Der Anschluß UgsQ1 erlaubt eine von der Regelung unabhängige Ib-Einstellung.

Die Schaltung gemäß FIG 8 unterscheidet sich von der in FIG 7 durch Verwendung von normally-off-Feldeffekttransistoren.

Der Vorteil beider Schaltungen liegt darin, daß der Betriebsstrom Ib weitgehend nur noch mit den gewählten Größen Rh und Uh, bzw. mit einem externen Widerstand Rhh festgelegt werden kann.

Bei beiden Schaltungen kann statt der Hilfsspannung Uh bzw. Uhh auch eine externe Hilfsstromquelle mit einem vorgegebenen Hilfsstrom Ihh angeschlossen sein; dann wird die Regelung spannungsunabhängig.
Die bei Feldeffekttransistoren üblichen Idss-Schwankungen werden in ihrem Einfluß minimiert.
Die Schaltung nach FIG 8 mit FETs vom normally-off-type hat zusätzlich den Vorteil, daß keine negative Hilfsspannung -Uh benötigt wird. Der Anschluß UgsQ1 erlaubt auch hier eine von der Regelung unabhängige Id-Einstellung.

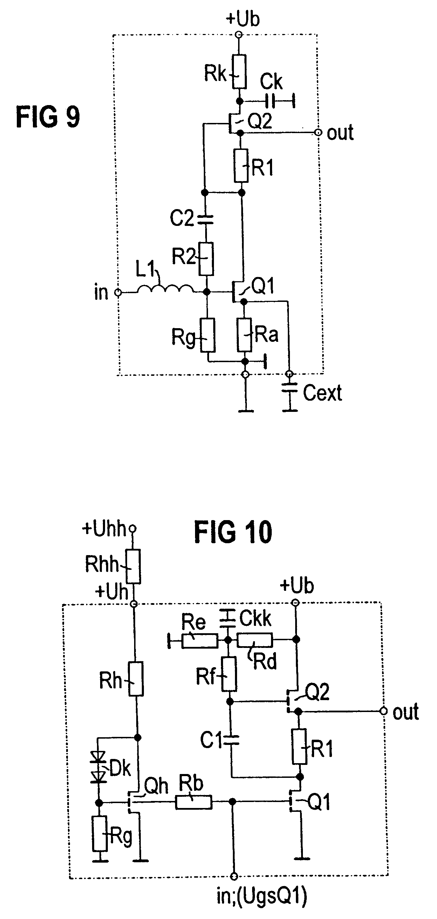

FIG 9 zeigt als Schaltungsanordnung eine komplette Verstärkerzelle mit einer kombinierten Eingangsanpassung aus resistiver Rückkopplung mit R2, C2 und transformativer Eingangsanpassung mit L1 ohne Ib-Regelung. Dieser Verstärkerblock (Gain block) einfacher Ausführung ist mit einer kombinierten Eingangsanpassung versehen, die je nach gewünschten Eigenschaften unterschiedlich gewichtet sein kann. Die transformatorische Anpassung kann auch mit mehreren Reaktanzen ausgeführt werden. Der Kondensator C2 dient der DC-Trennung von D1, G1. Der Kondensator Ck ist für interne HF-Erdung von Drain D2 des zweiten Feldeffekttransistors Q2 vorgesehen. Der Widerstand Rk (niederohmig, z.B. 10 Ohm) unterbindet parasitäre Resonanzen z.B. mit weiteren externen Masse-Erdungskondensatoren. Der Kondensator Cext dient der HF-Erdung von Source S1 des Feldeffekttransistors Q1.

In FIG 10 ist die Schaltungsanordnung einer Betriebsstrom Ib- geregelten Verstärkerzelle für externe Eingangsanpassung in einfacher Ausführung dargestellt. Der Kondensator C1 dient der DC-Trennung und HF-Verbindung Drain D1 von Transistor Q1 und Gate G2 von Transistor Q2. Die Spannung für G2 von Q2 wird über den Spannungsteiler Re, Rd aus Ub gewonnen und zur HF- Trennung über den Widerstand Rf dem Gate G2 des Feldeffekttransistors Q2 zugeführt.

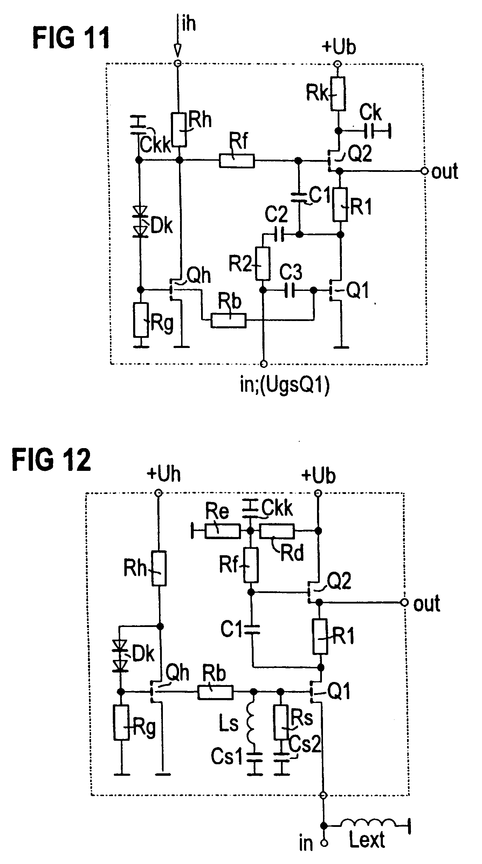

FIG 11 zeigt als Schaltungsbeispiel eine Betriebsstrom Ibgeregelte Verstärkerzelle mit interner resistiver Breitband- Gegenkopplung zur Eingangsanpassung. Die Kondensatoren C1, C2 und C3 dienen der DC-Trennung und bilden für das HF-Signal einen Durchgang. In diesem Ausführungsbeispiel wird der Hilfsstrom extern vorgegeben und die Spannung Ugs für den Feldeffekttransistor Q2 aus der sich einstellenden Drainspannung am Hilfstransitor Qh gewonnen.

In FIG 12 ist eine Schaltungsanordnung einer Betriebsstrom Ib-geregelten Verstärkerzelle als common gate Schaltung dargestellt. Eine solche Verstärkerzelle ist insbesondere für den niederfrequenten Einsatz bei Frequenzen kleiner 1GHz geeignet. Die Eingangsimpedanz ist niederohmig, beträgt etwa 50 Ohm und ist mit dem Betriebsstrom Ib und der Ausführung des ersten Feldeffekttransistors Q1 einfach realisierbar. Der Kondensasator Cs1 dient der HF-Erdung von Gate 1 des ersten Feldeffekttransistors Q1. Die Elemente Ls, Rs und Cs dienen der Stabilisierung (Schwingungsunterdrückung) des Breitbandverstärkers.

**Patentansprüche**

1. Monolithisch integrierter Mikrowellen-Breitbandverstärker mit zwei in Reihe geschalteten GaAs-Feldeffekttransistoren,
**dadurch gekennzeichnet**, daß zwischen der Drain-Elektrode (D1) des ersten Feldeffekttransistors (Q1) und der Source-Elektrode (S2) des zweiten Feldeffekttransistors (Q2) ein erster Widerstand (R1) liegt, daß die Drain-Elektrode (D1) des ersten Feldeffekttransistors (Q1) mit der Gate-Elektrode (G2) des zweiten Feldeffekttransistors (Q2) hochfrequenzmäßig verbunden ist, daß die Gate-Elektrode (G1) oder die Source-Elektrode (S1) des ersten Feldeffekttransistors (Q1) als Hochfrequenzsignal-Eingang dient, wobei die jeweils zweite Elektrode (S1 bzw. G1) hochfrequenzmäßig mit Masse verbunden ist, und daß die Source-Elektrode (S2) des zweiten Feldeffekttransistors (Q2) den Hochfrequenzsignal-Ausgang des Verstärkers bildet.

2. Verstärker nach Anspruch 1, **dadurch gekennzeichnet**, daß zwischen der Drain-Elektrode (D1) und der Gate-Elektrode (G1) des ersten Feldeffekttransistors (Q1) ein Rückkoppelnetzwerk vorgesehen ist.

3. Verstärker nach Anspruch 2, **dadurch gekennzeichnet**, daß das Rückkoppelnetzwerk aus einem Rückkoppelwiderstand (R2) oder aus einer Serienschaltung eines Widerstandes mit einem Kondensator gebildet ist.

4. Verstärker nach Anspruch 1, **dadurch gekennzeichnet**, daß zwischen Hochfrequenzsignal-Eingang und Gate-Elektrode (G1) des ersten Feldeffekttransistors (Q1) ein Anpaßnetzwerk vorgesehen ist.

5. Verstärker nach Anspruch 4, **dadurch gekennzeichnet**, daß als Anpaßnetzwerk eine Serieninduktivität (L1) vorgesehen ist.

6. Verstärker nach einem der Ansprüche 1 bis 5, **dadurch gekennzeichnet**, daß zwischen Source-Elektrode (S1) des ersten Feldeffekttransistors (Q1) und Masse ein Einstellwiderstand (Ra) geschaltet ist, dessen elektrische Werte denen des ersten Widerstandes (R1) entsprechen, und daß erster und zweiter Feldeffekttransistor (Q1, Q2) gleiche elektrische Werte aufweisen.

FIG 1

FIG 2

FIG 3

FIG 4

FIG 5

FIG 6

7

**FIG 7**

**FIG 8**

**FIG 9**

**FIG 10**

in;(UgsQ1)

**FIG 11**

in;(UgsQ1)

**FIG 12**

10

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US-A-3 286 189 (E. E. MITCHELL ET AL) * Spalte 3, Zeile 25 - Spalte 4, Zeile 22; Abbildung 4 * --- | 1 | H03F3/19 |
| Y | DE-A-27 32 625 (RCA) * Seite 20, Zeile 1 - Zeile 11; Abbildung 2 * --- | 1 | |
| Y | ELECTRONIC ENGINEERING, Bd.53, Nr.647, Januar 1981, LONDON GB Seiten 59 - 65 M. A. REHMAN 'MOSFET analog integrated circuits Part 3' * Seite 59, linke Spalte; Abbildung 34 * --- | 1 | |
| A | JOURNAL OF LIGHTWAVE TECHNOLOGY, Bd.6, Nr.11, November 1988, NEW YORK US Seiten 1665 - 1671 NORIO OHKAWA 'Fiber-optic multigigabit GaAs MIC front-end circuit with inductor peaking' * Seite 1667; Abbildung 2 * --- | 2-5 | |
| A | SIEMENS FORSCHUNGS- UND ENTWICKLUNGSBERICHTE, Bd.10, Nr.5, 1981, WÜRZBURG DE Seiten 280 - 288 E. PETTENPAUL ET AL 'Monolithische GaAs-Mikrowellenschaltkreise für Breitbandanwendungen' * Seite 284, Absatz 2; Abbildung 2 * --- | 2,3 | **RECHERCHIERTE SACHGEBIETE (Int.Cl.6)** H03F |
| A | PATENT ABSTRACTS OF JAPAN vol. 1, no. 35 (E-76) (1865) 15. April 1977 & JP-A-51 132 061 (TORIO) 16. November 1976 * Zusammenfassung * --- -/-- | | |

Der vorliegende Recherchenbericht wurde für alle Patentansprüche erstellt

| Recherchenort | Abschlußdatum der Recherche | Prüfer |
|---|---|---|
| BERLIN | 30. Juni 1994 | Breusing, J |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | IEEE MICROWAVE AND MILLIMETER-WAVE MONOLITHIC CIRCUITS SYMPOSIUM, 1. Juni 1992, ALBUQUERQUE Seiten 123 - 126 J. A. CASAO ET AL 'An enhanced GaAs monolithic transimpedance amplifier for low noise and high speed optical communications' * Seite 124, linke Spalte; Abbildung 1 * ----- | | |
| | | | **RECHERCHIERTE SACHGEBIETE (Int.Cl.6)** |

Der vorliegende Recherchenbericht wurde für alle Patentansprüche erstellt

| Recherchenort | Abschlußdatum der Recherche | Prüfer |
|---|---|---|
| BERLIN | 30. Juni 1994 | Breusing, J |